# EUROPEAN PATENT SPECIFICATION

(11) **EP 0 416 400 B1**
(45) Date of publication and mention of the grant of the patent: **07.02.1996**
(21) Application number: 90116275.0
(22) Date of filing: 24.08.1990
(51) Int. Cl.: C23C 16/44, C23G 5/00, B08B 7/00, H01L 21/285

(54) **Cleaning method for semiconductor wafer processing apparatus**
Reinigungsverfahren für eine Anlage zur Behandlung von Halbleiterscheiben
Méthode pour nettoyer un appareillage destiné au traitement de plaquettes semi-conductrices

(30) Priority: 22.09.1989 US 411433; 25.08.1989 US 398689
(43) Date of publication of application: 13.03.1991
(73) Proprietor: APPLIED MATERIALS INC., Santa Clara California 95052 (US)
(72) Inventor: Nagashima, Makoto, 1233 Yamazaki-cho Machida-shi (JP); Kobayashi, Naoaki, 1971-8 Usui Sakura-shi Chiba (JP); Wong, Jerry, Fremont California 94539 (US)
(74) Representative: DIEHL GLAESER HILTL & PARTNER

(56) References cited:
- EP-A- 0 237 153
- EP-A- 0 296 891
- PATENT ABSTRACTS OF JAPAN, vol. 12, no. 180 (P-709), 27th May 1988
- English translation of JP-A-62-291664

## Description

This invention relates to cleaning method for an apparatus used in the processing of semiconductor wafers. More particularly, this invention relates to an improvement in a method used for cleaning semiconductor wafer chemical vapor deposition apparatus.

In the deposition of materials on semiconductor wafers by chemical vapor deposition (hereinafter called "CVD deposition") or plasma assisted CVD deposition, coating residues such as, for example, silicon oxide or silicon nitride materials, are deposited on all exposed surfaces in the CVD deposition chamber, as well as the intended deposition on the semiconductor wafer. Such residues, which may accumulate to thicknesses of as much as 0.5 to 10 µm usually must be removed from the chamber prior to the next deposition.

Conventionally, the CVD chamber is cleaned to remove such residues using a fluorine plasma. While such a cleaning method is effective for removing such undesirable deposition residues, fluorine residues are, in turn, left on the CVD chamber surfaces by such a cleaning step. The presence of such fluorine residues, during a subsequent deposition, may adversely affect the deposited film quality, including poor step coverage, poor reproducibility of runs, and pinholes.

The problem of removing such unwanted fluorine residues has been dealt with in the prior art either by flushing the CVD deposition chamber with an inert gas to eventually remove a sufficient amount of the fluorine residue or by deposition of a thin layer of oxide or nitride over the fluorine residues, e.g., about 500 to 2000 Ångström* of oxide or nitride.
* Ångström = 0.1 nm

The first such solution to the problem, however, is time consuming, requiring as long as 10 minutes to adequately remove such fluorine residues by inert gas flushing. The second solution to the problem is somewhat self-defeating since the plasma fluorine cleaning step which results in the presence of the fluorine residues is intended to remove such oxide or nitride coatings.

Document JP-A 62 291 664 discloses an etching process in which the surface of an aluminium drum denatured from a previous exposure to a glow discharge plasma in the presence of carbon fluoride gas and oxygen is rough etched with a hydrogen glow discharge plasma.

It would, therefore, be desirable to provide an improvement in the method of cleaning CVD deposition apparatus to eliminate or mitigate the deleterious effects of such fluorine residues in the CVD deposition chamber of such apparatus.

The invention solves this problem by providing methods as evident from independent claim 1, Further advantageous features of this method are evident from the dependent claims, following description and enclosed drawing as well as the parallel EPO application EP-A-0 418 592 having the priority date of 25.08.89.

Therefore, this invention provides an improvement in a method for cleaning a CVD deposition chamber in a semiconductor wafer processing apparatus which comprises contacting fluorine residues, remaining therein from a plasma fluorine cleaning step, with one or more reducing gases.

It is another aspect of this invention to provide an improvement in a method for cleaning a CVD deposition chamber in a semiconductor wafer processing apparatus which comprises reacting fluorine residues, remaining therein from a plasma fluorine cleaning step, with one or more reducing gases to form one or more gaseous reaction products removable from the chamber.

It is yet another aspect of this invention to provide an improvement in a method for cleaning a CVD deposition chamber in a semiconductor wafer processing apparatus which comprises reacting fluorine residues, remaining therein from a plasma fluorine cleaning step, with one or more reducing gases to form one or more reaction products in the CVD deposition chamber which will not interfere with subsequent depositions.

These and other aspect of the invention will be apparent from the following description and accompanying flow sheet.

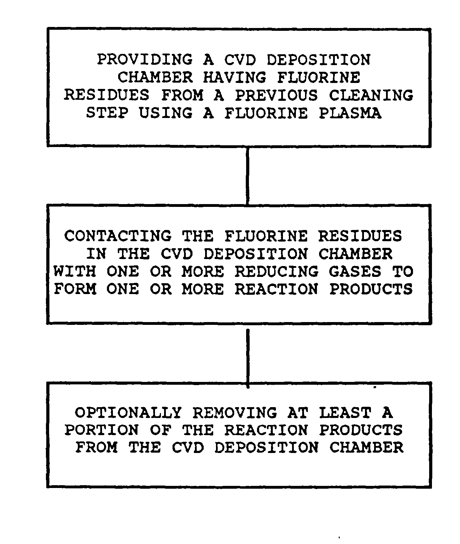

The sole drawing is a flow sheet illustrating the improved cleaning method of the invention.

The invention comprises an improvement in a method for cleaning a CVD deposition chamber in a semiconductor wafer processing apparatus wherein fluorine residues in the CVD deposition chamber, left from a prior fluorine plasma cleaning step, are contacted with one or more reducing gases.

Since the prior art fluorine plasma cleaning step may be used to remove deposition materials coated on the surfaces of either a plasma-assisted CVD deposition chambers or a non-plasma-assisted CVD deposition chamber, the invention may be used in connection with the treatment of the resulting fluorine residues formed in either a plasma-assisted CVD deposition chamber or a non-plasma-assisted CVD deposition chamber. It will, therefore, be understood that when a CVD deposition chamber is referred to herein in connection with the practice of the invention, the term is intended to include both types of deposition chambers unless further defined to the contrary.

The one or more reducing gases which contact the fluorine residues, in accordance with the invention, may comprise any reducing gases capable of reacting with the fluorine residues to form one or more reaction products. Examples of such reducing gases include silane (SiH₄), ammonia, hydrogen, phosphine (PH₃), diborine (B₂H₆), and arsine (AsH₃). Other reducing gases may be used, but silane, ammonia, and hydrogen are preferred since they do not introduce into the deposition chamber any elements other than those already in use in deposition processes usually conducted in the CVD deposition chamber, i.e., Si, N, and H. Mixtures of more than one reducing gas may also be used if desired.

The one or more reaction products which may be formed during contact of the fluorine residues with the one or more reducing gases may comprise one or more gaseous reaction products, which will then be removed from the CVD deposition chamber during the course of normal evacuation or pumping procedures used to maintain a vacuum with the chamber.

Alternatively, one or more solid reaction products may be formed by the reaction between the one or more reducing gases and the fluorine residues which may comprise particles or a coating on the chamber surfaces or a combination thereof. Such solid reaction products have been found (unlike the fluorine residues) to be relatively inert, i.e., to not interfere, with subsequent CVD deposition processes carried out in the chamber.

It is also possible that combinations of such gaseous and solid reaction products may be formed in the CVD deposition chamber.

The fluorine residues are contacted by the one or more reducing gases for a period of from as little as about 10 seconds up to 5 minutes or longer. While longer time periods may be used without any deleterious effects, such extended times usually are not necessary and, therefore, are not economically feasible. Usually when one or more solid reaction products are being formed in the chamber, contact times of less than a minute may be used, while in the formation of gaseous reaction products, contact periods of 1 minute or more may be preferred.

The one or more reducing gases are introduced into the CVD deposition chamber at a rate which may vary from as little as 100 sccm to as high as 500 sccm or higher, while maintaining the temperature in the chamber at from about 250 to about 500°C, preferably from about 350 to about 400°C.

In a preferred embodiment, the pressure in the CVD deposition chamber is maintained at from about 1 to about 20 Torr during the reaction between the one or more reducing gases and the fluorine residues. Pressures, however, as low as about 10-³ Torr*, or as high as about 100 Torr may be maintained during the reaction.
* 1 Torr = 1.333 mbar
1 mmHg = 1 Torr

To further illustrate the improvement in the method for cleaning a CVD deposition chamber in a semiconductor wafer processing apparatus, a silane (SiH₄) reducing gas was flowed for 10 seconds through a 5 liter CVD deposition chamber which had previously been cleaned using a fluorine plasma, leaving fluorine residues therein. The silane gas was flowed through the chamber at a rate of 200 sccm while the temperature of the chamber was maintained at a temperature of between 350-400°C.

Analysis of the chamber before and after the cleaning step of the invention showed that less than 1.0 % of the fluorine residues originally present in the chamber after cleaning with the fluorine plasma remained in unreacted form in the chamber after contact of the fluorine residues with the reducing gas in accordance with the invention. Analysis by secondary ion mass spectroscopy (SIMS) of a film subsequently deposited on a silicon wafer in the chamber showed that less than 5 x 10⁰ atoms/cm³ of fluorine were present in the deposited film.

To illustrate formation of a gaseous reaction product in the practice of the improvement in the method for cleaning a CVD deposition chamber in a semiconductor wafer processing apparatus, a silane (SiH₄) reducing gas was flowed for about 1 minute through a 5 liter CVD deposition chamber which had previously been cleaned using a fluorine plasma, leaving fluorine residues therein. The reducing gas was flowed through the chamber at a rate of 200 sccm while the temperature of the chamber was maintained at a temperature of between 350-400°C.

Analysis of the CVD deposition chamber after contact of the fluorine residues with the reducing gas showed less than 0.05 % of the original fluorine residues remaining in the CVD deposition chamber after the cleaning step of the invention. Analysis by SIMS of a film subsequently deposited on a silicon wafer in the chamber showed that less than 1 x 10¹⁹ atoms/cm³ of fluorine were present in the deposited film after cleaning by this method.

Thus, the invention provides an improvement in the method for cleaning a CVD deposition chamber wherein a fluorine plasma has been used to remove deposition materials from the surfaces of the deposition chamber resulting in the formation of fluorine residues wherein such fluorine residues are contacted with one or more reducing gases which react with the fluorine residues to form either gaseous reaction products removable from the deposition products or solid reaction products which will not interfere with subsequent depositions in the chamber, or mixtures of same.

The invention relates, according to a further aspect, to a method for cleaning a CVD deposition chamber, especially a method for cleaning the susceptor thereof, in which during the period of contacting the fluorine residues with one or more reducing gases, a plasma is ignited and/or mentioned in said chamber.

## Claims

1. A method of cleaning a chemical vapor deposition chamber that has been cleaned in a plasma containing fluorine, so that fluorine residues remain in the chamber,
characterized by
passing one or more reducing gases in the absence of a plasma at an elevated temperature of from 250° to 500°C into the chamber which is at a pressure of from 0.013 to 133.3 mbar (10⁻³ to 100 Torr) for at least ten seconds so as to react with said fluorine residues to form gaseous and/or solid reaction products.

2. The method according to claim 1, wherein said temperature is above 350°C.

3. The method according to claim 1 or 2, wherein said reducing gas is selected from the group consisting of silane, ammonia, hydrogen, phosphine, diborine and arsine.

4. The method according to one of the preceding claims, wherein the pressure of the chamber is maintained at from 1.333 to 26.66 mbar (1 to 20 Torr) during the reducing gas reaction step.

5. The method according to one of the preceding claims, wherein the reducing gas is passed into the chamber at a rate of from 100 to 500 sccm.

6. The method according to one of the preceding claims, wherein the reducing gas is silane.

## Patentansprüche

1. Verfahren zur Reinigung einer CVD-Kammer, die in einem fluorhaltigen Plasma gereinigt worden ist, so daß Fluorrückstände in der Kammer verbleiben,
gekennzeichnet durch
Leiten von einem oder mehreren reduzierenden Gasen in Abwesenheit eines Plasmas bei einer erhöhten Temperatur von 250° bis 500°C in die unter einem Druck von 0,013 bis 133,3 mbar (10⁻³ bis 100 Torr) stehende Kammer über einen Zeitraum von mindestens zehn Sekunden, um mit den Fluorrückständen zu reagieren, um gasförmige und/oder feste Reaktionsprodukte zu bilden.

2. Verfahren gemäß Anspruch 1, bei dem die Temperatur über 350°C liegt.

3. Verfahren gemäß Anspruch 1 oder 2, bei dem das reduzierende Gas aus der Gruppe bestehend aus Silan, Ammoniak, Wasserstoff, Phosphin, Diborin und Arsin ausgewählt wird.

4. Verfahren gemäß einem der vorhergehenden Ansprüche, bei dem der Druck der Kammer während des Schritts der Reaktion des reduzierenden Gases auf 1,333 bis 26,66 mbar (1 bis 20 Torr) gehalten wird.

5. Verfahren gemäß einem der vorhergehenden Ansprüche, bei dem das reduzierende Gas mit einer Geschwindigkeit von 100 bis 500 sccm in die Kammer geleitet wird.

6. Verfahren gemäß einem der vorhergehenden Ansprüche, bei dem es sich bei dem reduzierenden Gas um Silan handelt.

## Revendications

1. Procédé de nettoyage d'une chambre de dépôt de vapeur chimique qui a été nettoyée dans un plasma contenant du fluor, de telle sorte que des résidus fluorés restent dans la chambre, caractérisé par le passage d'un-ou plusieurs gaz réducteurs en l'absence d'un plasma à une température élevée comprise entre 250° et 500°C dans la chambre qui est à une pression comprise entre 0,013 et 133,3 mbar (10⁻³ à 100 Torr) pendant au moins dix secondes, de façon à réagir avec lesdits résidus fluorés pour former des produits de réaction gazeux et/ou solides.

2. Procédé selon la revendication 1, dans lequel ladite température est supérieure à 350°C.

3. Procédé selon la revendication 1 ou 2, dans lequel ledit gaz réducteur est choisi dans le groupe comprenant le silane, l'ammoniac, l'hydrogène, la phosphine, la diborine et l'arsine.

4. Procédé selon l'une des revendications précédentes, dans lequel la pression de la chambre est maintenue à une valeur comprise entre 1,333 et 26,66 mbars (1 à 20 Torr) pendant l'étape de réaction du gaz réducteur.

5. Procédé selon l'une des revendications précédentes, dans lequel le gaz réducteur traverse la chambre à un débit compris entre 100 et 500 cm³/mn.

6. Procédé selon l'une des revendications précédentes, dans lequel le gaz réducteur est le silane.
